# EUROPEAN PATENT SPECIFICATION

(11) **EP 0 797 266 B1**
(45) Date of publication and mention of the grant of the patent: **14.05.2003**
(21) Application number: 97301813.8
(22) Date of filing: 18.03.1997
(51) Int. Cl.: H01P 1/205, H01P 11/00

(54) **Dielectric filter and method of making same**
Dielektrisches Filter und Verfahren zu dessen Herstellung
Filtre diélectrique et procédé de fabrication

(30) Priority: 19.03.1996 JP 9194596
(43) Date of publication of application: 24.09.1997
(60) Divisional application: 02022883.9
(73) Proprietor: NGK Spark Plug Co. Ltd., Nagoya-shi Aichi-ken 467 (JP)
(72) Inventor: Ito, Kenji, c/o NGK Spark Plug Co., Ltd., Mizuho-ku, Aichi-ken 467 (JP)
(74) Representative: Brown, Kenneth Richard

(56) References cited:
- EP-A- 0 475 567
- US-A- 5 499 004
- PATENT ABSTRACTS OF JAPAN vol. 18, no. 549 (E-1618), 19 October 1994 & JP 06 196901 A (KYOCERA CORP), 15 July 1994,
- B. CHUBA: "Electroless copper/nickel shielding" PLATING AND SURFACE FINISHING, vol. 76, no. 9, September 1989, pages 30-33, XP002065652
- PATENT ABSTRACTS OF JAPAN vol. 95, no. 10, 30 November 1995 & JP 07 193403 A (MURATA MFG CO LTD), 28 July 1995,

## Description

### BACKGROUND OF THE INVENTION

### Field of the Invention:

The present invention relates to a dielectric filter to be mounted on a printed circuit board or the like, and to a method of making such a filter.

### Description of the Related Art:

In dielectric filters such as a dielectric filter having a coaxial resonator and a microstripline filter, silver baking is generally used to form a conductive layer on the surface of a ceramic substrate made of TiO₂-BaO-based dielectric, alumina, or the like. However, this method is expensive and involves a troublesome procedure of forming a conductive layer. Accordingly, in place of this method, an electroless copper-plating method is proposed, for example, in Japanese Patent Application Laid-Open (*kokai*) No. 54-108554.

However, when a conductive layer is formed by the electroless copperplating method, the conductive layer is likely to stain in air and to deteriorate due to sulfurnzation, resulting in an increased resistance, which in turn results in a decreased non-load Q value. This causes an increase in a filter insertion loss.

Japanese Patent Application 07-193403 relates to a dielectric resonator with an improved electrode pattern, which results in an improved Q value without enlarging the flat shape of the resonator. The outer electrodes of the resonator are covered by a protective layer.

### SUMMARY OF THE INVENTION

An object of the present invention is to provide a dielectric filter in which, even when a conductive layer is formed by electroless copper-plating, the conductive layer is free from stain and which allows a terminal portion of a conductive layer formed on the surface of the dielectric filter to be soldered to a conductive path formed on a printed circuit board to thereby establish electric connection therebetween.

The invention is defined by the appended claims.

According to a first aspect of the present invention, there is provided a dielectric filter for mounting on a printed circuit board, said filter including a dielectric substrate and a conductor layer formed on at least a portion of the surface of said substrate, wherein said conductor layer comprises an electroless copper plated layer on said surface, and a protective layer covering said electroless copper plated layer, characterised in that said protective layer comprises a synthetic resin which volatilises on an input/output portion due to heat in a solder process to a printed circuit board thereby establishing electric connection between said input/output portion of said filter and said printed circuit board.

The protective layer may be of vinyl chloride or a like synthetic resin.

Since the electroless copper-plated layer is protected from staining and sulfurization by the protective layer, there occurs no deterioration of characteristics such as a reduction in the non-load Q value. Further, the protective layer electrically insulates the electroless copper-plated layer to thereby prevent the occurrence of an undesirable electric short circuit. Also, when a dielectric filter having the above-described structure is mounted on a printed circuit board, an input/output portion of the dielectric filter is exposed to heat of molten solder. As a result, the corresponding portion of the protective layer vanishes due to the heat, whereby the input/output portion is soldered onto the printed circuit board to thereby establish electric connection therebetween.

### BRIEF DESCRIPTION OF THE DRAWINGS

FIG. 1 is a perspective view of a three-stage dielectric filter for high-frequency use according to an example;
FIG. 2 is a perspective view of the dielectric filter of FIG. 1 as viewed from behind;
FIG. 3 is a sectional view of the dielectric filter taken along line A-A in FIG. 2;
FIG. 4 is a sectional view showing the structure of conductive layer x for illustrative purposes;
FIG. 5 is a sectional view showing the structure of conductive layer y according to one embodiment of the present invention;
FIG. 6 is a sectional view of the conductive layer y to which molten solder is applied;
FIG. 7 is a graph showing test results for sample B and comparative sample C;
FIG. 8 is a sectional view showing the structure of conductive layer z according to another embodiment of the present invention;
FIG. 9A is a perspective view of a microstripline filter as viewed from the front side of the filter;
FIG. 9B is a perspective view showing part of the microstripline filter as viewed from the back side of the filter; and
FIGS. 10A to 10D are views schematically illustrating a procedure of forming a conductive pattern through use of a conductive layer x.

### DESCRIPTION OF THE PREFERRED EMBODIMENTS

Embodiments of the present invention will next be described in detail with reference to the drawings.

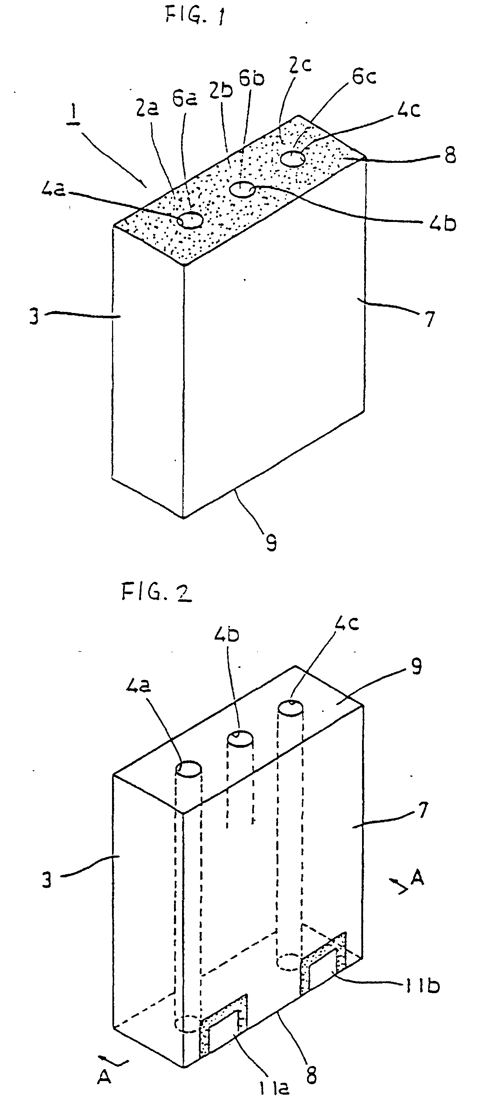

FIGS. 1 to 3 show a 3-pole dielectric filter 1 for high-frequency use according to an example. The 3-pole dielectric filter 1 includes a single dielectric block substrate 3 and three dielectric coaxial resonators 2a, 2b, and 2c.

The dielectric block substrate 3 is made of titanium oxide-based ceramic dielectric and has a rectangular parallelepiped shape. Three through-holes 6a, 6b, and 6c corresponding to the dielectric coaxial resonators 2a, 2b, and 2c are formed in the dielectric block substrate 3. Inner conductive layers 4a, 4b, and 4c are formed on the surfaces of the through-holes 6a, 6b, and 6c, respectively. The outer surface of the dielectric block substrate 3, except one end surface thereof, is covered with an outer conductive layer (grounding conductor) 7. The end surface not covered with the outer conductive layer 7 forms an open end surface 8. The other end surface of the dielectric block substrate 3 forms a short-circuiting end surface 9 which connects the inner conductive layers 6a, 6b, and 6c to each other via the outer conductive layer 7.

Input/output portions 11a and 11b are formed on one side of the dielectric block substrate 3 adjacent to the open end surface 8 in a manner insulated from the outer conductive layer 7. The input/output portion 11a is capacitively connected to the inner conductive layer 6a via the dielectric block substrate 3, and the input/output portion 11b is capacitively connected to the inner conductive layer 6c via the dielectric block substrate 3.

Either the input/output portion 11a or 11b is connected to the input terminal of a predetermined conductive path on a printed circuit board while the other is connected to the output terminal of the predetermined conductive path, thereby electrically connecting the dielectric filter 1 to the printed circuit board. This electrical connection is established by soldering.

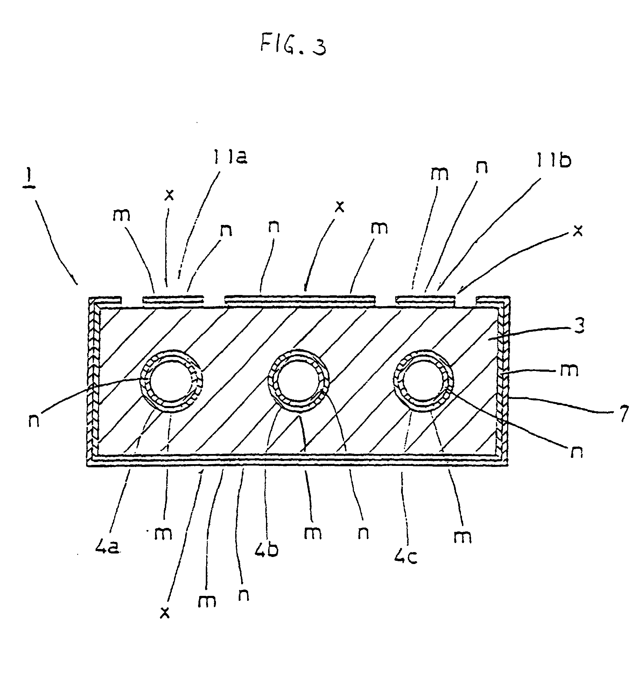

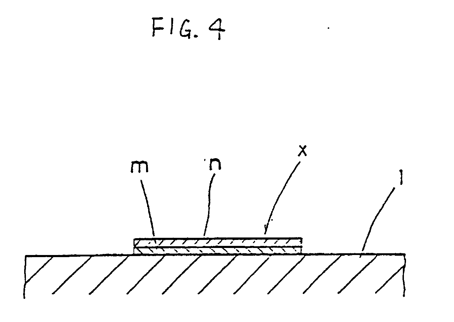

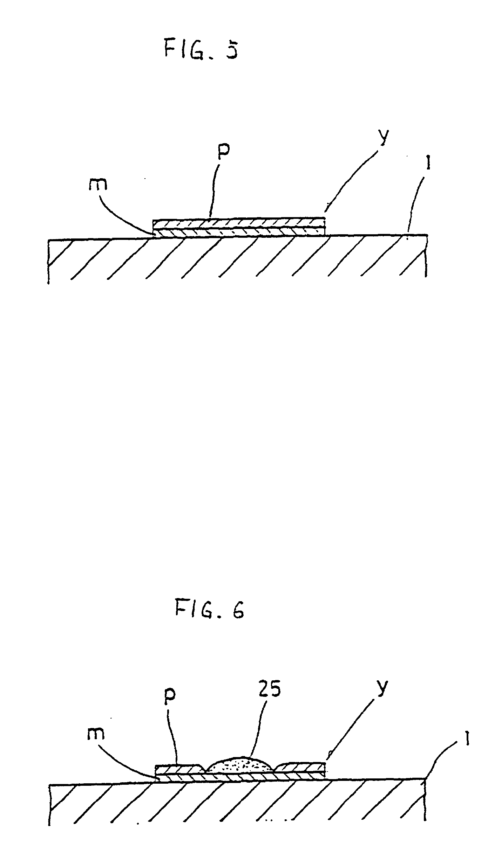

As shown in FIG. 3, the inner conductive layers 6a, 6b, and 6c, the outer conductive layer 7, and the input/output portions 11a and 11b comprise a conductive layer x. The conductive layer x, in turn, comprises an electroless copper-plated layer m, and a conductive covering layer n having good electric conductivity and good solder wettability and formed on the surface of the electroless copper-plated layer m.

The inner conductive layers 6a, 6b, and 6c, the outer conductive layer 7, and the input/output portions 11a and 11b are formed in the steps of forming the electroless copper-plated layer m on the dielectric block substrate 3 and forming the conductive covering layer n on the surface of the electroless copper-plated layer m.

The thickness of the electroless copper-plated layer m may take any value, but is preferably 1 to 40 µm for easy formation of the layer. The conductive covering layer n is formed of Ni-B alloy through electroless deposition of Ni-B alloy (NIBORON, MNP-M2, Trade name, product of World Metal Co. Ltd.) conducted for about 30 minutes. When the dielectric filter 1 is to be used in a high frequency band, the thickness of the conductive covering layer n is preferably 0.04 to 1 µm because of a smaller conduction loss, but is not limited thereto. This layer thickness can be adjusted as needed through adjustment of time of electroless deposition.

The Ni-B alloy used as material for the conductive covering layer n has good solder wettability. Accordingly, the input/output portions 11a and 11b can be readily soldered to a predetermined conductive paths on a printed circuit board.

The conductive covering layer n may be formed of the Ni-P alloy or the Ni-B-P alloy. The Ni-B, Ni-P, and Ni-B-P alloys all show good adhesion to copper although the degree of adhesion depends on their pretreatments. After deposition, the alloys have fewer pinholes and show better corrosion resistance as compared with electroplated nickel.

A conductive layer x was formed on a dielectric substrate to make a sample A. Only an electroless copper-plated layer m having the same thickness as that of the electroless copper-plated layer m of the sample A was formed on a dielectric substrate to make a comparative sample C. The sample A and the comparative sample C were left for 100 hours in a high-temperature high-humidity environment maintained at a temperature of 45°C and a relative humidity of 95% and containing 50 PPM of H₂S. Subsequently, the non-load Q values of the samples A and C were measured.

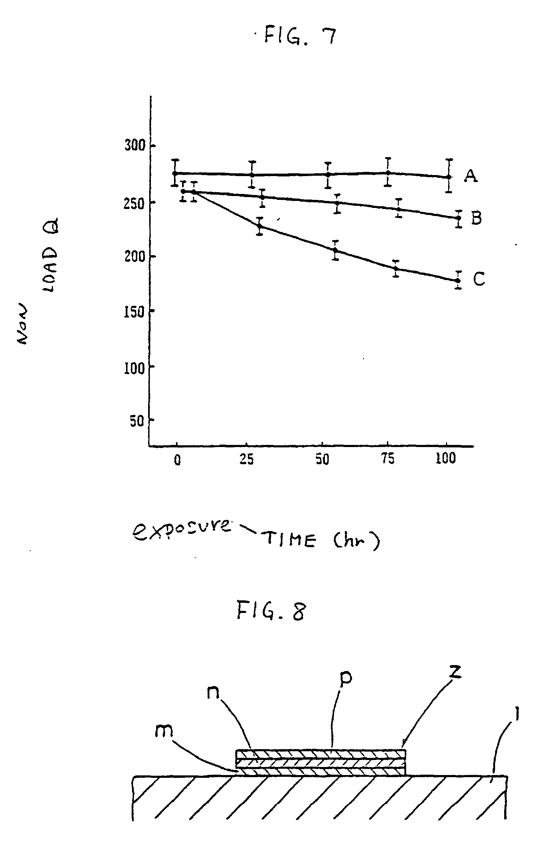

FIG. 7 shows the results of the measurement on the non-load Q value in the above-described test. As seen from FIG. 7, in the high-temperature high-humidity environment, a reduction in the non-load Q value is smaller in the sample A, wherein the conductive layer x comprises the electroless copper-plated layer m covered with the conductive covering layer n, than in the comparative sample C, wherein the conductive layer comprises only a single electroless copper-plated layer m.

An embodiment of the present invention will next be described.

As shown in FIGS. 5 and 6, a conductive layer y comprises an electroless copper-plated layer m formed on the surface of a dielectric block substrate 1, and a protective synthetic resin layer p of vinyl chloride formed on the surface of the electroless copper-plated layer m. The protective layer p may be formed of any synthetic resin which will vanish upon exposure to heat of molten solder; that is to say, it will volatilize upon being heated to a temperature above the flow temperatures of conventional metal solders. For example, Pb-Sn solders have flow temperatures, or melting points which vary with the Pb content. A Pb 36-Sn 64 eutectic alloy metal solder has a melting point of about 183°C, while a Pb 90 -Sn 10 alloy has a melting point of about 301°C. The particular solder to be used can be selected according to the volatilizing characteristics of the synthetic resin.

The above-described structure is attained by the steps of electrolessly depositing the electroless copper-plated layer m on the dielectric block substrate 1 and dipping the thus-coated dielectric block substrate 1 in a solution which is prepared by diluting a synthetic resin such as vinyl chloride with a solvent. Thus, the protective layer p is formed on the surface of the electroless copper-plated layer m.

A sample B having the thus-formed conductive layer y was left in a high-temperature high-humidity environment to undergo the same test as for the Sample A and the Comparative Sample C described above. The results of the measurement on the non-load Q value in the test are shown in FIG. 7. A seen from FIG. 7, the Sample B, like the Sample A, also shows excellent non-load Q characteristic as compared with the Comparative Sample C. Being protected by the protective layer p, the electroless copper-plated layer m is prevented from staining associated with exposure to moist air, thereby providing stable non-load Q characteristic.

The protective layer p provides electrical insulation for the electroless copper-plated layer m. Accordingly, the protective layer p seems to hinder establishing an electrical connection between the input/output portions 11a and 11b and predetermined conductive paths formed on a printed circuit board. However, as shown in FIG. 6, when molten solder is applied to a terminal portion of the conductive layer y via the protective layer p, the solder-applied portion of the protective layer p vanishes due to heat of molten solder. As a result, an electrical connection can readily be established between the terminal portion and the predetermined conductive path formed on the printed circuit board via a solder 25.

By contrast, for the portion other than the terminal portion of the conductive layer y, the corresponding portion of the electroless copper-plated layer m is electrically insulated by the protective layer p. Accordingly, even when the inner conductive layer 4a, 4b, or 4c or the outer conductive layer 7 mechanically contacts another electric device on a printed circuit board, no short circuit occurs therebetween.

FIG. 8 shows a conductive layer z according to another embodiment of the present invention. As shown in FIG. 8, a dielectric filter comprises a dielectric block substrate 1 or a dielectric ceramic substrate 21 (described later) and the conductive layer z formed on the substrate 1 or 21. The conductive layer z comprises an electroless copper-plated layer m formed on the surface of the substrate, a conductive covering layer n having good electric conductivity and good solder wettability and formed on the surface of the electroless copper-plated layer m, and a protective synthetic resin layer p of vinyl chloride formed on the surface of the conductive covering layer n. In this structure of the conductive layer z, the electroless copper-plated layer m is protected from staining and sulfurization by the conductive covering layer n and the protective layer p. Thus, there occurs no deterioration of characteristics such as a reduction in the non-load Q value. Further, the protective layer p electrically insulates the conductive layer surface to thereby prevent the occurrence of an undesirable electric short circuit. When a terminal portion formed on the dielectric substrate is exposed to heat of molten solder, the corresponding portion of the top protective synthetic resin layer vanishes due to the heat. As a result, the underlying conductive covering layer n is exposed. The thus-exposed portion of the conductive covering layer n provides good solder connection because of its good solder wettability. That is, the conductive layer z provides effects of both the conductive layers x and y.

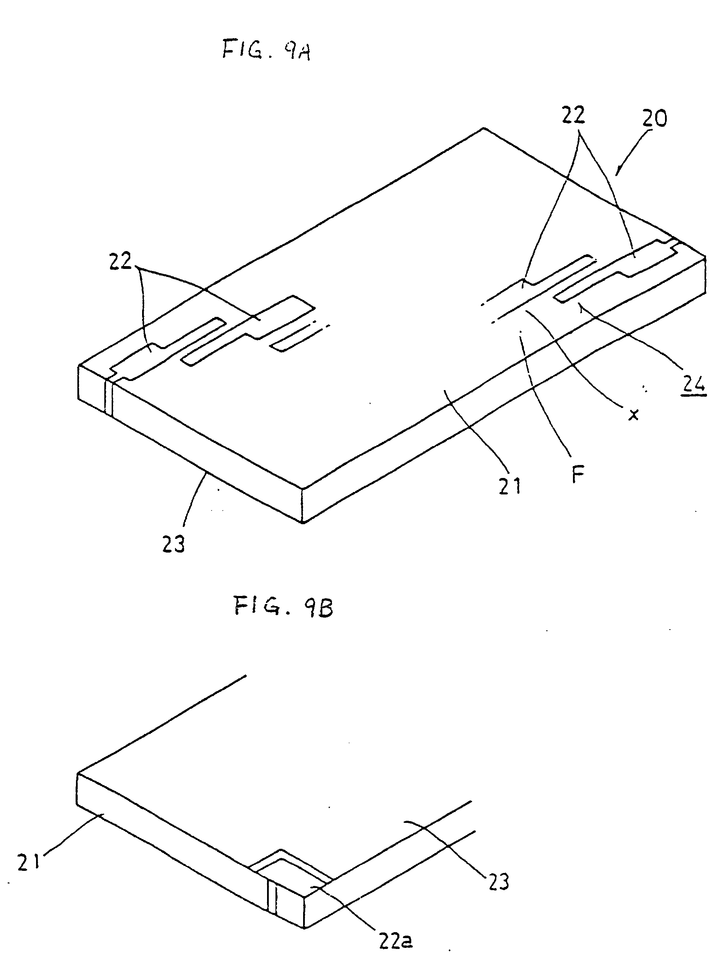

The present invention is also applicable to a microstripline filter 20 shown in FIGS. 9A and 9B. As shown in FIG. 9A, a plurality of strip-shaped resonant conductive layers 22 are arranged in parallel on the surface of a dielectric ceramic substrate 21 to thereby form a parallel coupling type microstripline filter circuit F. The strip-shaped resonant conductive layers 22 are mutually coupled through an electromagnetic field established across a gap therebetween. A shield conductive layer 23 is formed on the other side of the dielectric ceramic substrate 21. The dielectric ceramic substrate 21 is made of alumina or a TiO₂-BaO based material. Among a plurality of the resonant conductive layers 22, both outermost resonant conductive layers 22 extend across end surfaces of the dielectric ceramic substrate 21 and to the opposite side of the dielectric ceramic substrate 21 as shown in FIG. 9B. On the opposite side of the dielectric ceramic substrate 21, the extended portions of the resonant conductive layers 22 are insulated from the surrounding shield conductive layer 23 and are used as input/output portions 22a for surface mounting.

Conductive patterns 24 such as the resonant conductive layers 22 and 23 comprise a conductive layer x. The conductive layer x, as shown in FIG. 4, comprises an electroless copper-plated layer m, and a conductive covering layer n having good electric conductivity and good solder wettability and formed on the surface of the electroless copper-plated layer m.

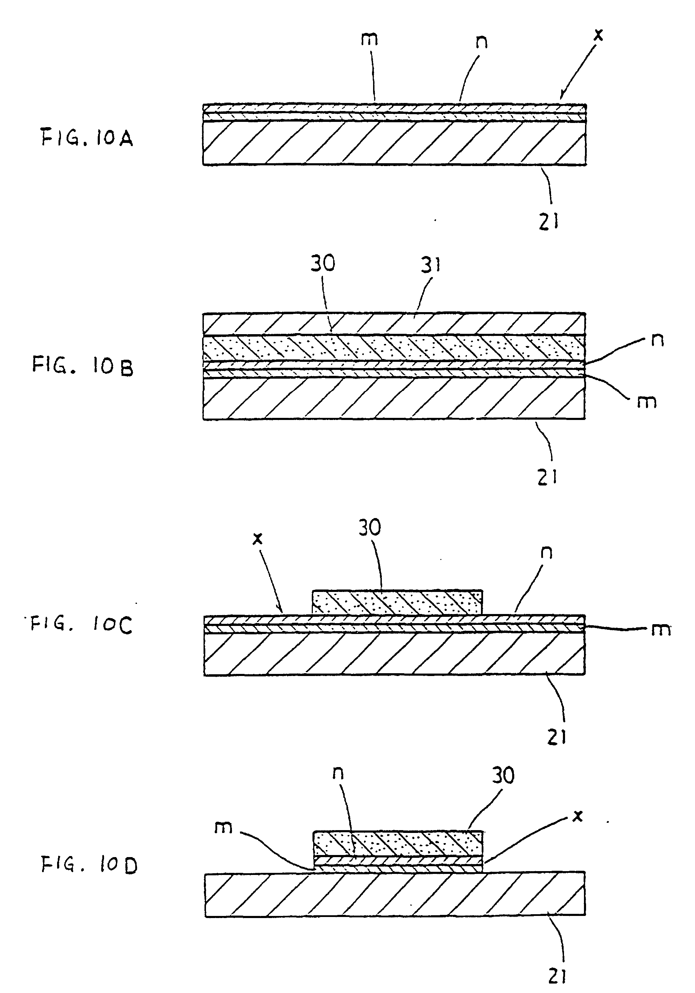

Through use of this conductive layer x, a predetermined conductive pattern 24 is formed on the dielectric ceramic substrate 21 in the following manner. As shown in FIG. 10A, the electroless copper-plated layer m is formed on the surface of the dielectric ceramic substrate 21, and the conductive covering layer n is formed on the surface of the electroless copper-plated layer m, followed by thermal treatment at a temperature of 500°C in an oxygen environment. As shown in FIG. 10B, a photosensitive resist film 30 is attached to the entire surface of the conductive covering layer n. A negative film 31 on which a conductive pattern is developed is placed on the resist film 30, followed by exposure. As a result, only a portion of the resist film 30 corresponding to a conductive portion of the conductive pattern is exposed to light. The non-exposed portion of the resist film 30 is removed by etching. As a result, as shown in FIG. 10C, a portion of the resist film 30 corresponding to the potential conductive layer x remains unetched. Then, an unnecessary portion of the electroless copper-plated layer m and of the conductive covering layer n is removed by etching through use of an etching solution of copper chloride or the like, to thereby obtained the form shown in FIG. 10D. Subsequently, the resist film 30 remaining on the conductive layer x is removed through use of a diluted solution of sodium hydroxide. As a result, as shown in FIG. 9A, on the dielectric ceramic substrate 21 is formed the conductive pattern 24 of the conductive layer x, which comprises the electroless copper-plated layer m and the conductive covering layer n.

## Claims

1. A dielectric filter (1) for mounting on a printed circuit board, said filter including a dielectric substrate (3) and a conductor layer (4a, 4b, 4c, 7) formed on at least a portion of the surface of said substrate, wherein said conductor layer (4a, 4b, 4c, 7) comprises an electroless copper plated layer (m) on said surface, and a protective layer (p) covering said electroless copper plated layer (m),
**characterised in that** said protective layer (p) comprises a synthetic resin which volatilises on an input/output portion (11a, 11b) due to heat in a solder process to a printed circuit board thereby establishing electric connection between said input/output portion (11a, 11b) of said filter and said printed circuit board.

2. A dielectric filter (1) for mounting on a printed circuit board, said filter including a dielectric substrate (3) and a conductor layer (4a, 4b, 4c, 7) formed on at least a portion of the surface of said substrate, wherein said conductor layer (4a, 4b, 4c, 7) comprises an electroless copper plated layer (m) on said surface, a conductive covering layer (n) on the surface of said electroless copper plated layer (m), said conductive covering layer (n) comprising a nickel-base alloy applied to said electroless copper plated layer by electroless deposition or electrodeposition, and a protective layer (p) covering said conductive covering layer (n),
**characterised in that** said protective layer (p) comprises a synthetic resin which volatilises on an input/output portion (11a, 11b) due to heat in a solder process to a printed circuit board thereby establishing electric connection between said input/output portion (11a, 11b) of said filter and said printed circuit board.

3. A dielectric filter according to claim 1 or 2, wherein said synthetic resin layer consists essentially of vinyl chloride.

4. The dielectric filter according to claim 2, wherein said conductive covering layer (n) consists essentially of an alloy selected from the group consisting of Ni-B alloys, Ni-P alloys and Ni-B-P alloys.

5. A method of making a dielectric filter (1) for mounting on a printed circuit board, said filter including a dielectric substrate (3) and a conductor layer (4a, 4b, 4c, 7) formed on at least a portion of the surface of said substrate (3), wherein for forming said conductor layer (4a, 4b, 4c, 7) the method comprises forming a copper layer (m) on said surface by electroless deposition, and wherein a protective layer (p) is formed covering said copper layer (m), said protective layer (p) comprises a synthetic resin which volatilises on an input/output portion (11a, 11b) due to heat in a solder process to a printed circuit board thereby establishing electric connection between said input/output portion (11a, 11b) of said filter and said printed circuit board.

6. A method of making a dielectric filter (1) for mounting on a printed circuit board, said filter including a dielectric substrate (3) and a conductor layer (4a, 4b, 4c, 7) formed on at least a portion of the surface of said substrate (3), wherein for forming said conductor layer (4a, 4b, 4c, 7) the method comprises forming a copper layer (m) on said surface by electroless deposition, forming a conductive covering layer (n) of a nickel-base alloy on the surface of said copper layer (m) by electroless deposition or electrodeposition, and wherein a protective layer (p) is formed covering said conductive covering layer (n), said protective layer (p) comprises a synthetic resin which volatilises on an input/output portion (11a, 11b) due to heat in a solder process to a printed circuit board thereby establishing electric connection between said input/output portion (11a, 11b) of said filter and said printed circuit board.

## Patentansprüche

1. Dielektrisches Filter (1), das auf einer Platine befestigbar ist, mit einem dielektrischen Substrat (3) und einer Leitschicht (4a, 4b, 4c, 7), die zumindest auf einem Teil der Substratfläche ausgebildet ist, wobei die Leitschicht (4a, 4b, 4c, 7) auf dieser Fläche eine chemische Kupferniederschlagsschicht (m), und eine die chemische Kupferniederschlagsschicht (m) bedeckende Schutzschicht (p), umfasst,
**dadurch gekennzeichnet, dass**
die Schutzschicht (p) ein synthetisches Harz umfasst, das an einem Eingangs-/Ausgangsbereich (11a, 11b) aufgrund der Hitze bei einem Lötprozess an der Platine verdampft, aodurch eine elektrische Verbindung zwischen dem Eingangs-/Ausgangsbereich (11a, 11b) des Filters und der Platine erzeugt wird.

2. Dielektrisches Filter (1), das auf einer Platine befestigbar ist, mit einem dielektrischen Substrat (3) und einer Leitschicht (4a, 4b, 4c, 7), die zumindest auf einem Teil der Substratfläche ausgebildet ist, wobei die Leitschicht (4a, 4b, 4c, 7) auf dieser Fläche eine chemische Kupferniederschlagsschicht (m), auf der Fläche der chemischen Kupferniederschlagsschicht (m) eine leitende Deckschicht (n) mit einer nickelbasierten Legierung, die auf der chemischen Kupferniederschlagsschicht durch chemischen Niederschlag oder galvanische Metallabscheidung ausgebildet ist, und eine die leitende Deckschicht (n) bedeckende Schutzschicht (p) aufweist,
**dadurch gekennzeichnet, dass**
die Schutzschicht (p) ein synthetisches Harz umfasst, das an einem Eingangs-/Ausgangsbereich (11a, 11b) aufgrund der Hitze bei einem Lötprozess an der Platine verdampft, wodurch eine elektrische Verbindung zwischen dem Eingangs-/Ausgangsbereich (11a, 11b) des Filters und der Platine ausgebildet wird.

3. Dielektrisches Filter nach Anspruch 1 oder 2, wobei die synthetische Harzschicht im wesentlichen aus Vinylchlorid besteht.

4. Dielektrisches Filter nach Anspruch 2, wobei die leitende Deckschicht (n) im wesentlichen aus einer Legierung besteht, die aus der aus Ni-B-Legierungen, Ni-P-Legierungen und Ni-B-P-Legierungen bestehenden Gruppe ausgewählt ist.

5. Verfahren zum Herstellen eines dielektrischen Filters (1), das an einer Platine befestigbar ist, wobei das Filter ein dielektrisches Substrat (3) und eine Leitschicht (4a, 4b, 4c, 7) umfasst, die zumindest auf einem Teil der Substratfläche (3) ausgebildet ist, wobei zum Ausbilden der Leitschicht (4a, 4b, 4c, 7) das Verfahren das Ausbilden einer Kupferschicht (m) auf dieser Fläche durch chemischen Niederschlag umfasst, und wobei eine die Kupferschicht (m) bedeckende Schutzschicht (P) ausgebildet wird, die ein synthetisches Harz umfasst, das an einem Eingangs-/Ausgangsbereich (11a, 11b) aufgrund der Hitze bei einem Lötprozess an der Platine verdampft, wodurch eine elektrische Verbindung zwischen dem Eingangs-/Ausgangsbereich (11a, 11b) des Filters und der Platine ausgebildet wird.

6. Verfahren zum Herstellen eines dielektrischen Filters (1), das an einer Platine befestigbar ist, wobei das Filter ein dielektrisches Substrat (3) und eine Leitschicht (4a, 4b, 4c, 7) umfasst, die zumindest auf einem Teil der Substratfläche (3) ausgebildet ist, wobei zum Ausbilden der Leitschicht (4a, 4b, 4c, 7) das Verfahren das Ausbilden einer Kupferschicht (m) auf dieser Fläche durch chemischen Niederschlag und das Ausbilden einer leitenden Deckschicht (n) aus einer nickelbasierten Legierung auf der Fläche der Kupferschicht (m) durch chemischen Niederschlag oder galvanische Metallabscheidung umfasst, und wobei eine die leitende Deckschicht (n) bedeckende Schutzschicht (p) gebildet wird, die ein synthetisches Harz aufweist, das an einem Eingangs-/Ausgangsbereich (11a, 11b) aufgrund der Hitze bei einem Lötprozess an der Platine verdampft, wodurch eine elektrische Verbindung zwischen dem Eingangs-/Ausgangsbereich (11a, 11b) des Filters und der Platine hergestellt wird.

## Revendications

1. Filtre diélectrique (1) destiné à être monté sur une carte de circuits imprimés, ledit filtre comprenant un support diélectrique (3) et une couche conductrice (4a, 4b, 4c, 7) formée sur au moins une partie de la surface du support, ladite couche conductrice (4a, 4b, 4c, 7) comprenant une couche de cuivre (m) déposée par un procédé sans courant sur ladite surface, et une couche protectrice (p) recouvrant ladite couche de cuivre (m) déposée par un procédé sans courant,
filtre diélectrique **caractérisé en ce que** ladite couche protectrice (p) comprend une résine synthétique qui se volatilise sur une partie entrée/sortie (11a, 11b) sous l'effet de la chaleur produite par un procédé de soudure à une carte de circuits imprimés, ce qui établit une liaison électrique entre ladite partie entrée/sortie (11a, 11b) dudit filtre et ladite carte de circuits imprimés.

2. Filtre diélectrique (1) destiné à être monté sur une carte de circuits imprimés, ledit filtre comprenant un support diélectrique (3) et une couche conductrice (4a, 4b, 4c, 7) formée sur au moins une partie de la surface du support, ladite couche conductrice (4a, 4b, 4c, 7) comprenant une couche de cuivre (m) déposée par un procédé sans courant sur ladite surface, une couche conductrice (n) recouvrant la surface de ladite couche de cuivre (m) déposée par un procédé sans courant, ladite couche conductrice de recouvrement (n) comprenant un alliage à base de nickel qui est appliqué sur ladite couche de cuivre déposée par un procédé sans courant, par un procédé de dépôt sans courant ou par dépôt électrolytique, et une couche protectrice (p) recouvrant ladite couche conductrice de recouvrement (n),
filtre diélectrique **caractérisé en ce que** ladite couche protectrice (p) comprend une résine synthétique qui se volatilise sur une partie entrée/sortie (11a, 11b) sous l'effet de la chaleur provoquée par un procédé de soudure à une carte de circuits imprimés, ce qui établit une liaison électrique entre ladite partie entrée/sortie (11a, 11b) dudit filtre et ladite carte de circuits imprimés.

3. Filtre diélectrique selon la revendication 1 ou 2, pour lequel ladite couche de résine synthétique est constituée essentiellement de poly(chlorure de vinyle).

4. Filtre diélectrique selon la revendication 2, pour lequel ladite couche conductrice de recouvrement (n) est constituée essentiellement d'un alliage choisi parmi les alliages Ni-B, les alliages Ni-P et les alliages Ni-B-P.

5. Procédé de fabrication d'un filtre diélectrique (1) destiné à être monté sur une carte de circuits imprimés, ledit filtre comprenant un support diélectrique (3) et une couche conductrice (4a, 4b, 4c, 7) formée sur au moins une partie de la surface du support (3), procédé dans lequel, pour former ladite couche conductrice (4a, 4b, 4c, 7), on forme sur ladite surface une couche de cuivre (m) par un procédé de dépôt sans courant, et on forme une couche protectrice (p) recouvrant ladite couche de cuivre (m), ladite couche protectrice (p) comprenant une résine synthétique qui se volatilise sur une partie entrée/sortie (11a, 11b) sous l'effet de la chaleur provoquée par un procédé de soudure à une carte de circuits imprimés, ce qui établit une liaison électrique entre ladite partie entrée/sortie (11a, 11b) dudit filtre et ladite carte de circuits imprimés.

6. Procédé de fabrication d'un filtre diélectrique (1) destiné à être monté sur une carte de circuits imprimés, ledit filtre comprenant un support diélectrique (3) et une couche conductrice (4a, 4b, 4c, 7), formée sur au moins une partie de la surface dudit support (3), procédé dans lequel, pour former ladite couche conductrice (4a, 4b, 4c, 7), on forme sur ladite surface une couche de cuivre (m) par un procédé de dépôt sans courant, on forme sur la surface de ladite couche de cuivre (m), par un procédé de dépôt sans courant ou par dépôt électrolytique, une couche conductrice de recouvrement (n), constituée d'un alliage à base de nickel, et on forme une couche protectrice (p) qui recouvre ladite couche conductrice de recouvrement (n), ladite couche protectrice (p) comprenant une résine synthétique qui se volatilise sur une partie entrée/sortie (11a, 11b) sous l'effet de la chaleur produite par un procédé de soudure à une carte de circuits imprimés, ce qui établit une liaison électrique entre ladite partie entrée/sortie (11a, 11b) dudit filtre et ladite carte de circuits imprimés.
